# EUROPÄISCHE PATENTSCHRIFT

(11) **EP 0 349 562 B1**
(45) Veröffentlichungstag und Bekanntmachung des Hinweises auf die Patenterteilung: **09.06.1993**
(21) Anmeldenummer: 88902468.3
(22) Anmeldetag: 16.03.1988
(51) Int. Cl.: G03F 3/10, G03C 11/14

(54) **VERFAHREN UND MITTEL ZUR DURCHFÜHRUNG VON KOPIERTECHNISCHEN PRÜFDRUCKVERFAHREN**
PROCESS AND MEANS FOR PERFORMING PRINT PROCESSES USING COPYING TECHNOLOGY
PROCEDE ET MOYEN D'EXECUTION DE PROCEDES D'IMPRESSION D'EPREUVES UTILISANT DES TECHNIQUES DE REPRODUCTION

(30) Priorität: 17.03.1987 DE 3708586
(43) Veröffentlichungstag der Anmeldung: 10.01.1990
(73) Patentinhaber: E.I. DU PONT DE NEMOURS AND COMPANY, Wilmington Delaware 19898 (US)
(72) Erfinder: OSENEGG, Carlfried, D-5206 Neunkirchen-Seelscheid (DE)
(74) Vertreter: Werner, Hans-Karsten, Dr.Dipl.-Chem.
(86) Internationale Anmeldenummer: EP8800211
(87) Internationale Veröffentlichungsnummer: WO8807223

(56) Entgegenhaltungen:
- DE-A- 1 597 642
- FR-A- 336 533
- FR-A- 886 612
- FR-A- 1 562 858
- FR-A- 2 270 620
- GB-A- 2 013 932
- US-A- 2 010 188
- US-A- 2 604 398
- US-A- 3 135 608
- US-A- 4 115 125
- US-A- 4 304 836
- LEXIKON DER GRAPHISCHEN TECHNIK, Seite 34

## Beschreibung

Gegenstand der vorliegenden Erfindung ist ein Verfahren und ein Mittel zur Durchführung von kopiertechnischen Prüfdruckverfahren für den Farbdruck, bei dem mindestens ein lichtempfindlicher Film auf einer Unterlage auflaminiert, belichtet und mit einem trockenen Toner angefärbt wird.

Derartige Prüfdruckverfahren für den Farbdruck verdrängen im zunehmenden Maße den klassischen Andruck im Tief- und Offsetdruck. Statt einer Vielzahl von Einflußgrößen, die beim Andruck aufeinander abgestimmt werden müssen, verlangen kopiertechnische Farbprüfsysteme nur zwei Punkte, die standardisiert und kontrolliert werden müssen, nämlich die Belichtungszeit und die Pigmentierung (Toner).

Diese Systeme bieten eine sichere Aussage, ob die Farbauszüge (Filme) optimal sind und welche Korrekturen vorgenommen werden müssen. Hinzu kommt die schnellere Verfügbarkeit des Farbprüfdruckes. Der automatische Transport des Farbprüfdruck-Trägers durch die Pigmentierungsanlage verlangt allerdings mehr mechanische Stabilität als die normalen für den endgültigen Druck vorgesehenen Papiere aufweisen. Das Prüfdruckverfahren wird daher üblicherweise mit Hilfe eines Kartons durchgeführt. Dieser Karton führt allerdings häufig zu Andruckergebnissen, die besser aussehen als das spätere Druckergebnis.

Es sind deshalb schon viele Versuche unternommen worden, das für den endgültigen Druck vorgesehene Papier zusammen mit einem stabilen Träger-Karton für die Dauer des Arbeitsablaufes vom Laminieren des lichtempfindlichen Films über die Belichtung bis zum Passieren der Pigmentierungsmaschine zu verbinden. Nach Ablauf des Verfahrens muß es jedoch leicht möglich sein, das Papier zerstörungsfrei wieder vom Träger zu lösen. Versuche mit Träger-Kartons mit schwach haftender Kleberbeschichtung haben sich nicht bewährt, da Schwankungen in der Klebkraft und in der Rupffestigkeit des Papieres immer wieder zu Fehlergebnissen geführt haben. In der Praxis hat man sich auch damit zu helfen versucht, daß man den Träger-Karton am Rand mit Leim bestreicht oder das für den endgültigen Druck vorgesehene Papier mit doppelseitig haftenden Klebebändern auf den Karton klebt. Der damit verbundene zusätzliche manuelle Aufwand und vor allem die unsichere Passerhaltung bei mehreren Farbübertragungen sprechen gegen diese Methode.

In GB-A-2 013 932 wird ein photographisches Kopiermaterial für den photographischen Satz von Druckvorlagen, beispielsweise für Zeitungen, beschrieben, das ein Substrat enthält, welches auf der einen Seite mit einem lichtempfindlichen Film und auf der anderen Seite mit einer selbstklebenden Schicht und einem entfernbaren Schutzfilm oder Schutzpapier versehen ist.

Im "Lexikon der graphischen Technik", 7. Auflage, Seite 34 ist unter dem Stichwort "Andrucken" ausgeführt, daß Auflagenpapier auch für den Andruck verwendet werden kann.

Die Erfindung hat sich die Aufgabe gestellt, ein Verfahren und ein Mittel zur Durchführung von kopiertechnischen Prüfdruckverfahren für den Farbdruck zu entwickeln, bei dem mindestens ein lichtempfindlicher Film auf einer Unterlage auflaminiert, belichtet und mit einem trockenen Toner angefärbt wird, bei dem es möglich ist, das Verfahren auf einer Probe des für den endgültigen Druck vorgesehenen Papiers durchzuführen und das dennoch technisch so einwandfrei verläuft, wie man es von dem bisher verwendeten stabilen Träger-Karton gewohnt ist.

Diese Aufgabe kann überraschend einfach dadurch gelöst werden, daß mindestens ein lichtempfindlicher Film auf einer Probe des für den endgültigen Druck vorgesehenen Papiers auflaminiert wird, welches seinerseits abziehbar auf einem form- und maßstabilen Träger aufgebracht worden ist, dann belichtet und mit einem trockenen Toner angefärbt wird, wobei das für den endgültigen Druck vorgesehene Papier zuvor auf der Rückseite mit einer Zwischenschicht versehen wird, die von dem Träger zerstörungsfrei abgezogen werden kann. Das Mittel besteht somit aus einem form- und maßstabilen Träger, auf dem eine Probe des für den endgültigen Druck vorgesehen Papiers haftet, welches auf der Rückseite mit einer Zwischenschicht versehen ist, die von dem Träger zerstörungsfrei abgezogen werden kann.

Die Rückseite des für den endgültigen Druck vorgesehenen Papiers wird beispielsweise mit einem porenschließenden Trennlack vorbehandelt, der eine klebeabweisende Oberfläche bildet. Dieser Trennlack wird vorzugsweise aus organischen Lösungsmitteln aufgetragen und enthält beispielsweise als klebeabweisende Komponente PE, PVDC, PU, Polyester oder Silikone. Wegen der Verwendung der organischen Lösungsmittel empfiehlt sich diese Methode insbesondere für die großtechnische Vorfertigung unter Verwendung mehrerer standardisierter und häufig verwendeter Druckpapiere.

Bei Verwendung von seltener verwendeten Druckpapieren besteht die Möglichkeit, ohne Verwendung organischer Lösungsmittel eine einseitig selbstklebende Folie aufzulaminieren. Derartige einseitig selbstklebende Folien sind bereits im Handel erhältlich und werden beispielsweise von der Firma Neschen angeboten.

Eine weitere Methode der definierten Vorbehandlung der Rückseite des für den endgültigen Druck vorgesehenen Papiers besteht in dem heißen Auflaminieren einer Heißsiegelfolie. Hierbei ist jedoch darauf zu achten, daß durch die Heißlaminierung nicht die Qualität des Druckpapieres verändert wird.

Die Oberfläche des Trägers wird beispielsweise dadurch vorbehandelt, daß man sie mit einem schwachen Haftkleber beschichtet. Eine weitere Möglichkeit ist die Beschichtung der Oberfläche des Trägers mit einer Haftfolie. Auf derartigen Haftfolien haften die oben beschriebenen vorbehandelten Papiere ebenfalls so ausreichend, daß die nachfolgenden Verfahrensschritte, nämlich Laminieren, Belichten und Tonen, einwandfrei durchgeführt werden können und danach der Probedruck auf einer Probe des für den endgültigen Druck vorgesehenen Papiers leicht abgezogen werden kann. Die so erhaltenen Probedrucke entsprechen völlig den endgültigen Druckerzeugnissen und werden nicht durch die andere Papierqualität des für Probedrucke üblichen Kartons verfälscht.

Als Träger, deren Oberfläche vorbehandelt worden sind, kommen ebenfalls die bisher üblichen Kartons in Frage, sofern sie bezüglich Gewicht, Dicke und Stabilität den Anforderungen entsprechen. Es ist jedoch nicht mehr nötig, sie in spezieller Weise zu beschichten, wie dies bei den bisher üblichen Probekartons üblich war.

Eine weitere Möglichkeit besteht erfindungsgemäß in der Verwendung einer form- und maßstabilen Folie zum Beispiel aus Polyester, auf die ebenfalls entweder der schwache Haftkleber, insbesondere aber eine Haftfolie aufgebracht worden ist. Form- und maßstabile Polyesterfolien sind im allgemeinen teurer als Karton. Insbesondere aber bei Beschichtung mit einer Haftfolie sind sie nicht in der Lage, Toner anzunehmen, so daß sie auch mehrfach verwendet werden können. Dies kann den Preisnachteil gegenüber Karton leicht überkompensieren. Sie werden daher in erster Linie dort zum Einsatz kommen, wo mit wechselnden Papierqualitäten gearbeitet wird und das jeweils vorgesehene Papier mit einer einseitig selbstklebenden Folie vorbehandelt wird.

Die folgenden Versuche wurden durchgeführt mit dem Farbprüfsystem "Cromalin" ^{(R)} der Firma Du Pont de Nemours (Deutschland) GmbH. Es wurde anstelle des für den Probedruck üblichen Kartons Kromekote ^{(R)} (300g/qm) das jeweils für den endgültigen Druck vorgesehene Papier verwendet.

### Beispiel 1:

Standardtypen von Druckpapier wurden einseitig mit der Lösung eines Trennlackes beschichtet und auf einen Karton aufgebracht, der einseitig mit einem schwachen Haftkleber beschichtet war. Diese Kombination aus Träger und Papier wurde in üblicher Weise nach dem Cromalin-Verfahren laminiert, belichtet und getont. Danach wurde der Probedruck abgezogen. Er entsprach wesentlich besser den endgültigen Druckerzeugnissen als vergleichweise hergestellten Probedrucken auf Kromekote-Karton.

### Beispiel 2:

Als Träger wurde eine 130 µm starke PTP-Folie mit einer 200 µm starken Schicht Weich-PVC laminiert. Auf der Weich-PVC-Schicht hafteten sowohl die gemäß Beispiel 1 vorbehandelten Papiere als auch andere Papiere, die auf der Rückseite mit einer einseitig selbstklebenden Folie der Firma Neschen beschichtet worden waren. Dieser Träger konnte mehrfach verwendet werden, ohne seine Qualität einzubüßen oder durch Tonerreste angefärbt zu werden. Insbesondere bei der Herstellung mehrerer Probedrucke wird erfindungsgemäß viel Platz und Gewicht eingespart, da die Probedrucke nur geringfügig dicker und schwerer sind als die endgültigen Druckerzeugnisse, aber wesentlich dünner und leichter sind als die bisherigen Probedrucke auf Karton.

## Patentansprüche

1. Verfahren zur Durchführung von kopiertechnischen Prüfdruckverfahren für den Farbdruck, bei dem mindestens ein lichtempfindlicher Film auf einer Probe des für den endgültigen Druck vorgesehenen Papiers auflaminiert wird, welches seinerseits abziehbar auf einem form- und maßstabilen Träger aufgebracht worden ist, dann belichtet und mit einem trockenen Toner angefärbt wird, dadurch gekennzeichnet, daß das für den endgültigen Druck vorgesehene Papier zuvor auf der Rückseite mit einer Zwischenschicht versehen wird, die von dem Träger zerstörungsfrei abgezogen werden kann.

2. Verfahren gemäß Anspruch 1, dadurch gekennzeichnet, daß die Rückseite des Papiers mit einem porenschließenden Trennlack vorbehandelt ist, der eine kleberabweisende Oberfläche bildet.

3. Verfahren gemäß Anspruch 1, dadurch gekennzeichnet, daß auf die Rückseite des Papiers eine einseitig selbstklebende Folie auflaminiert ist.

4. Verfahren gemäß einem der Ansprüche 1 bis 3, dadurch gekennzeichnet, daß die Oberfläche des Trägers mit einem schwachen Haftkleber beschichtet ist.

5. Verfahren gemäß einem der Ansprüche 1 bis 3, dadurch gekennzeichnet, daß die Oberfläche des Trägers mit einer Haftfolie beschichtet ist.

6. Mittel zur Durchführung des Verfahrens gemäß Ansprüchen 1 bis 5, bestehend aus einem form- und maßstabilen Träger, auf dem eine Probe des für den endgültigen Druck vorgesehenen Papiers haftet, welches auf der Rückseite mit einer Zwischenschicht versehen ist, die von dem Träger zerstörungsfrei abgezogen werden kann.

7. Mittel gemäß Anspruch 6, dadurch gekennzeichnet, daß der Träger aus Karton oder einer form- und maßstabilen Polyesterfolie besteht.

## Claims

1. A process for performing proofing for colour printing based on copier technology, wherein at least one light-sensitive film is laminated to a sample of the paper which is intended to be used in the actual printing process, which paper in turn has been attached, so that it can be stripped off, to the surface of a dimensionally stable support, is then exposed and dyed with a dry toner, characterized in that the paper which is intended to be used in the actual printing process in advance is provided on the back thereof with an intermediate layer which may be stripped from the support without damage.

2. The process according to claim 1, characterized in that the back of the paper is pretreated with a pore-sealing release resin which forms a surface that rejects adhesives.

3. The process according to claim 1, characterized in that the back of the paper has been laminated with a one-sided self-adhesive film.

4. The process according to one of the claims 1 to 3, characterized in that the surface of the support is coated with a weak pressure-sensitive adhesive.

5. The process according to one of the claims 1 to 3, characterized in that the support is coated with an adhesive film.

6. A means for performing the process according to claims 1 to 5, consisting of a dimensionally stable support to which a sample of the paper which is intended to be used in the actual printing process has been attached, said paper having been provided on the back thereof with an intermediate layer which may be stripped from the support without damage.

7. The means according to claim 6, characterized in that the support consists of cardboard or a dimensionally stable polyester film.

## Revendications

1. Procédé pour l'exécution de procédé d'impression d'épreuves pour l'impression en couleur, utilisant des techniques de reproduction, dans lequel au moins un film photo-sensible est déposé sous forme d'une couche sur un échantillon du papier destiné à l'impression finale, lequel de son côté est déposé de manière à pouvoir être enlevé sur un support stable en forme et dimension puis est exposé et est teinté au moyen d'un toner sec, caractérisé en ce que le papier destiné à l'impression finale est préalablement muni, sur son verso, d'une couche intermédiaire qui peut être détachée du support sans dommage.

2. Procédé selon la revendication 1, caractérisé en ce que le verso du papier est traité préalablement au moyen d'une laque isolante à pore fermé qui constitue une surface anti-adhésive.

3. Procédé selon la revendication 1, caractérisé en ce que, sur le verso du papier, est déposée sous forme d'une couche une feuille auto-adhésive sur une seule face.

4. Procédé selon une des revendications 1 à 3, caractérisé en ce que la face supérieure du support est recouverte d'une colle de contact à faible pouvoir adhésif.

5. Procédé selon une des revendications 1 à 3, caractérisé en ce que la face supérieure du support est recouverte d'une feuille adhésive.

6. Moyens pour la mise en oeuvre du procédé selon les revendications 1 à 5, caractérisés par un support stable en forme et dimension sur lequel adhère un échantillon du papier destiné à l'impression finale qui est muni, sur son verso, d'une couche intermédiaire, laquelle peut être détachée du support sans dommage.

7. Moyens selon la revendication 6, caractérisés en ce que le support est constitué par du carton ou par une feuille de polyester stable en forme et dimension.
